# EUROPEAN PATENT APPLICATION

(11) **EP 0 614 224 A1**
(43) Date of publication of application: **07.09.1994**
(21) Application number: 94301506.5
(22) Date of filing: 02.03.1994
(51) Int. Cl.: H01L 27/118

(54) **Basic gate array cell with salicide power distribution**

(30) Priority: 05.03.1993 US 27018
(71) Applicant: SGS-THOMSON MICROELECTRONICS, INC., Carrollton Texas 75006 (US)
(72) Inventor: Waggoner, Charles David, Richardson, Texas 75080 (US)
(74) Representative: Palmer, Roger

(57) **Abstract**

A gate array comprised of basic cells is disclosed. Each cell in the gate array includes a silicide-clad diffused region isolated from the source/drain regions of the transistors in the cell. Metal connections are made to the silicide-clad diffused region periodically along its length, so that the silicide-clad diffused region distributes the power supply voltage to the cells without requiring overlying metallization which limits routing flexibility. A CMOS implementation is illustrated, in which silicide-clad diffused regions of both types are provided in each cell. Connection of the power supply voltage to the silicide-clad diffused regions also serves as well bias connections, to avoid latchup and leakage conditions.

## Description

This invention is in the field of integrated circuits, and is more specifically directed to gate array basic cells.

This application is related to European Patent Application No 94300652.8 the contents of which are incorporated herein by this cross reference.

In the field of electronic systems, the use of gate arrays to implement digital functions has become widespread in recent years. As is well known in the art, a gate array is an integrated circuit fabricated as a regular arrangement of transistors, which can be interconnected according to the desired digital function. The transistors are conventionally grouped into "basic cells", rather than as individual transistors, with each basic cell comprising a sufficient number of transistors to implement an elemental logic function (i.e., a "gate"). A basic cell (often also referred to as a "base cell", "basic block", or "functional block") corresponds to a step-and-repeat silicon structure, from which a circuit function is realized by the routing of overlying metal or other conductive elements.

The use of gate arrays allows for the rapid production of customized digital circuits. This results from the fabrication of integrated circuit wafers with the transistors in the basic cells defined by lower level physical elements, but with the actual digital circuit function not defined until later stages in the manufacturing process. In the case of MOS gate arrays, the basic cell transistors are defined by source and drain diffusions and first level polysilicon gate electrodes. Metal interconnections are then defined to interconnect the transistor elements according to the desired circuit function. This process allows the customized arrangement of the gates, or cells, to be implemented at the latest stages in the manufacturing process, reducing the design-to-manufacture time of the digital circuit. Custom integrated circuits may thus be produced at very short cycle times, and with a minimum number of custom photomasks.

The cost of gate array implementations, as is the case with other integrated circuits, depends upon the amount of semiconductor area used to implement the function, and also upon the complexity of the manufacturing process. An important element of gate array design includes the distribution of power supply voltages to the transistors in those cells used in the circuit implementation. The power supply lines, for example V_{dd} and Vₛₛ power supply lines, must of course not contact one another nor contact signal lines in the integrated circuit in order to obtain functionality. As such, power supply distribution is a significant factor not only in cell utilization, but also in determining manufacturing process complexity, particularly relative to the number of interconnection levels to be used.

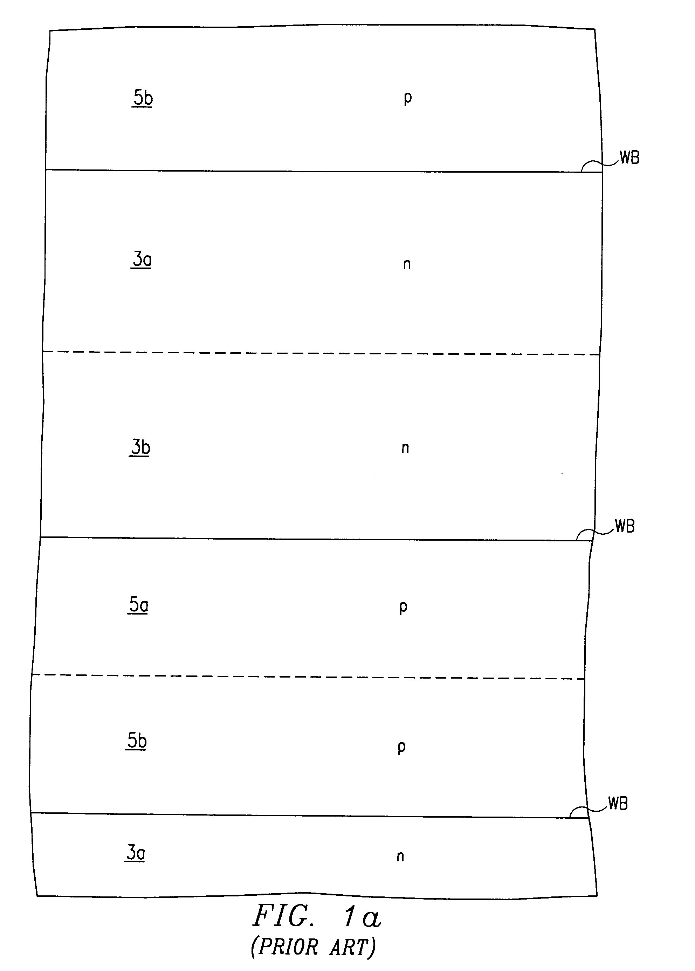

Referring now to Figures 1a through 1d, a conventional power distribution system for a CMOS gate array will now be described. Referring first to Figure 1a, the arrangement of n-type and p-type wells at the surface of a semiconductor wafer is illustrated. N-type wells 3a, 3b constitute regions within which p-channel MOS transistors will be formed, while p-type wells 5a, 5b constitute regions within which n-channel MOS transistors will be formed, and between which well boundary WB is present. As is conventional for CMOS gate arrays, a basic cell includes at least one p-channel transistor and at least one n-channel transistor. Accordingly, basic cells in this conventional arrangement will include a portion of adjacent well regions of opposite conductivity type. For example, a single basic cell will include a portion of n-well 3b and a portion of p-well 5a.

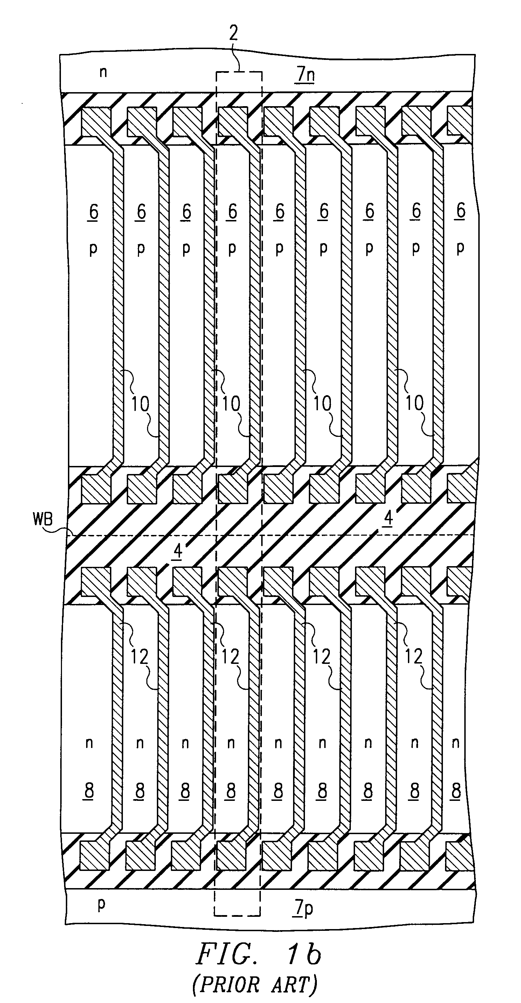

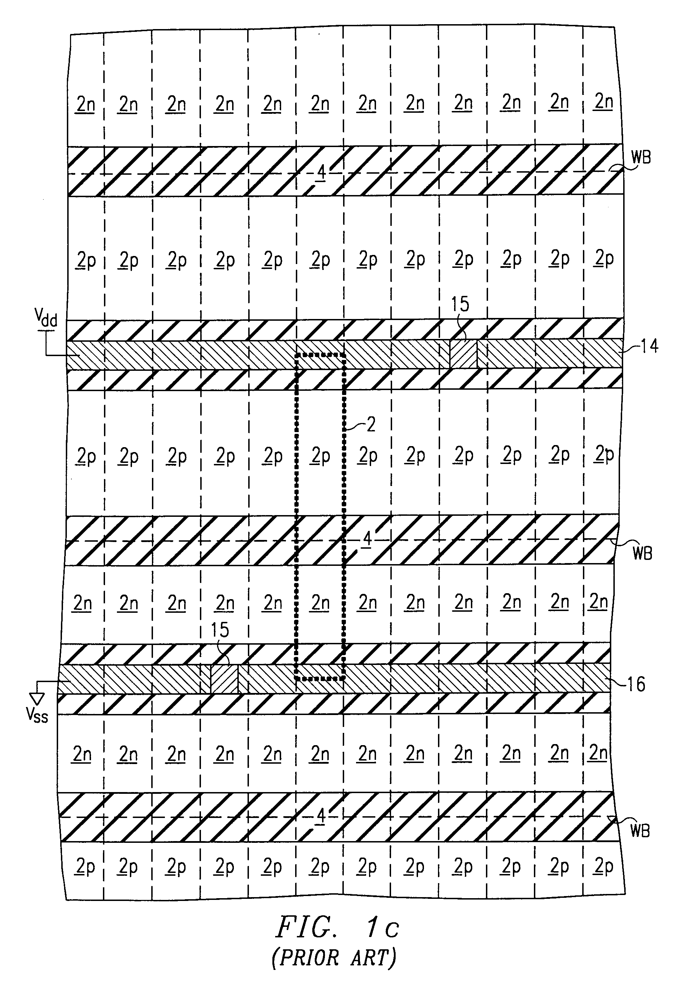

Referring now to Figure 1b, the construction of a conventional basic cell 2 in the well arrangement of Figure 1a is illustrated. Each conventional cell 2 includes polysilicon electrode 10 and polysilicon electrode 12, each of which have enlarged pad regions at their terminal ends which overlie field oxide 4. The p-channel transistor in cell 2 is implemented by polysilicon electrode 10 which is disposed between (and overlies) p-type diffused regions 6 in the conventional manner for MOS transistors, such that the p-type diffused region 6 on either side of electrode 10 serve as the source and drain regions for the p-channel transistor with electrode 10 serving as the gate for the transistor. Similarly, electrode 12 in cell 2 is disposed between and above n-type diffused regions 8, so that n-type diffused regions 8 may serve as source and drain, and electrode 12 as the gate, of an n-channel MOS transistor. It is preferred that p-type diffused regions 6 and n-type diffused regions 8 be formed as diffusions performed after electrodes 10, 12 are in place, so that the transistors defined thereby are according to the well-known self-aligned configuration. P-type diffused regions 6 are separated from n-type diffused regions 8 by field oxide 4 therebetween, overlying well boundary WB. The isolation technique used in this conventional arrangement is the cutoff transistor type, in which an adjacent transistor to that for which the function is desired is forced into its "off" state, preventing conduction from the transistors used to perform the digital logic function.

Disposed outside of electrodes 10 in cell 2 of Figure 1b are active regions 7n, 7p. Active region 7n is an n-type diffusion within n-well 3, while active region 7p is a p-type diffusion within p-well 5. Active regions 7n, 7p are shared with similar active regions in adjacent cells above and below (in the orientation of Figure 1b) cell 2.

Figure 1c illustrates the provision of first metal level power distribution for the cell arrangement of Figures 1a and 1b. According to this arrangement, the portion of the wells remains exposed between transistor regions of the same type. As such, no field oxide 4 is present between n-type wells 3a, 3b, or between p-type wells 5a, 5b, at the locations indicated by the dashed lines of Figure 1a. Figure 1c also illustrates generally the location of cells 2, each of which includes p-channel transistor cell portion 2p and an n-channel transistor cell portion 2n.

As illustrated in Figure 1c, first metal level electrodes 14, 16 overlie the boundaries between n-type wells 3a, 3b and p-type wells 5a, 5b, respectively. Periodic contacts 15 are made between metal lines 14, 16 and underlying active regions 7n, 7p in wells 3, 5, through interlevel dielectric layers, to provide the proper well bias so that leakage and latchup are avoided. In this example, first metal level electrode 14 is biased positive (i.e., to V_{dd}), and as such is connected to n-type wells 3a, 3b via contact 15 and active region 7n within cell portions 2p. Similarly, first metal level electrode 16 is biased to ground (i.e., to Vₛₛ), and is connected to p-type wells 5a, 5b via contact 15 and active region 7p within cell portions 2n.

These connections between metal lines 14, 16 and active regions 7n, 7p via contacts 15 are only adequate as well tie-downs (i.e., to bias wells 3, 5 to V_{dd} or ground), however. This is because the relatively high resistivity of active regions 7n, 7p limits the current that may be conducted thereby to a level below that required to distribute power to cells 2. Bias of the source, drain and gate portions of transistors within cells 2 according to this conventional arrangement therefore requires metal straps connected between metal lines 14, 16 and the desired portions of cells 2.

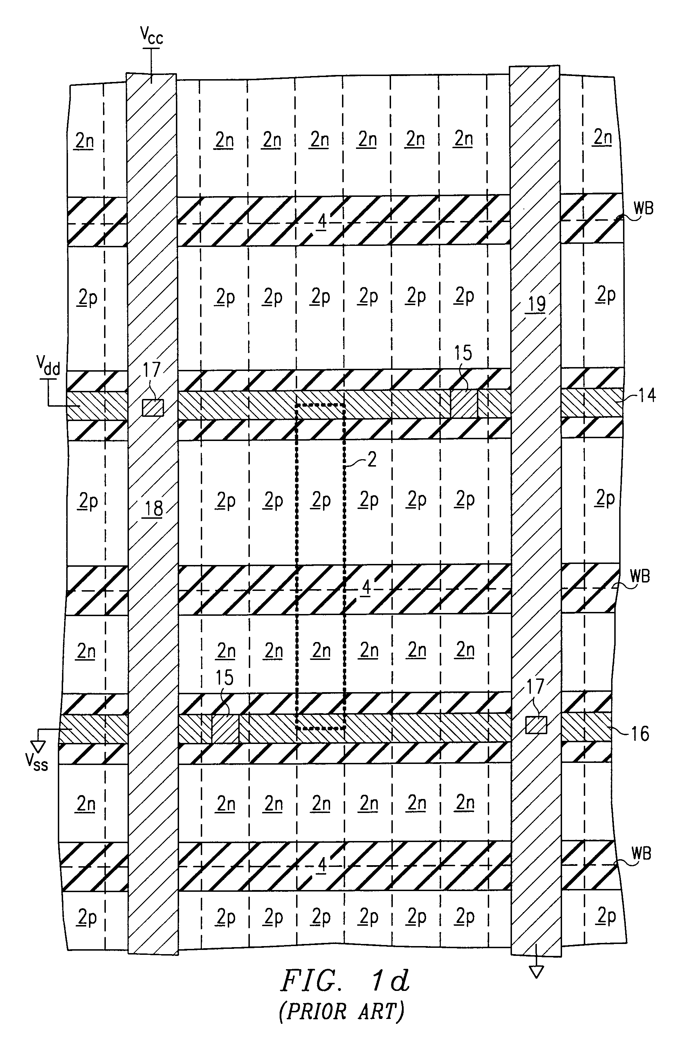

Referring now to Figure 1d, the provision of second metal level electrodes 18 and 19 are illustrated. Second metal level electrodes 18, 19 are perpendicular to first level metal electrodes 14, 16, and are separated therefrom by another interlevel dielectric. In this example, second metal level electrode 18 is biased to V_{dd} and makes contact to first metal level electrode 14 via contact 17; similarly, second metal level electrode 19 is biased to ground and makes contact to first metal level electrode 16 via contact 17. As such, this arrangement of metallization provides for power distribution in each perpendicular direction.

Modern CMOS gate arrays include third level metallization as well. If three metal levels are available for the gate array of Figures 1a through 1d, power distribution in the third metal level is conventionally accomplished by way of third metal electrodes overlying and parallel to first level metal electrodes 14, 16 of Figures 1c and 1d, with interlevel contacts making connection therebetween.

As is evident from Figures 1c and 1d, the use of metal levels for power distribution is quite disruptive to the routing of signal lines through the gate array. In the first metal level, signal lines may only run for reasonable distances in a horizontal direction (relative to Figures 1c and 1d), as the distance that such first level metal signal electrodes could run in the vertical direction is limited by the presence of first metal level electrodes 14, 16. Similarly, in the second metal level, signal lines could run for reasonable distances only in a vertical direction, given the presence of vertical second metal level electrodes 18, 19. As such, the arrangement of Figures 1a through 1d limits the routing of signal line metal conductors, and thus limits the utilization of basic cells 2 in the array for a given number of metal levels.

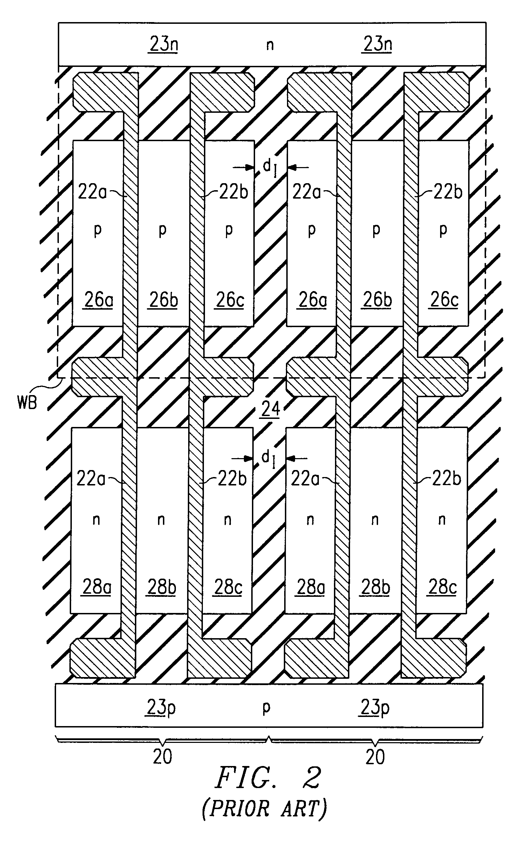

Figure 2 illustrates conventional basic cell 20 according to an oxide isolation scheme, but utilizing oxide isolation. Cells 20 of Figure 2 are constructed according to CMOS technology, and as such include p-type diffused regions 26a through 26c and n-type diffused regions 28a through 28c. Each cell 20 in this example includes two electrodes 22a, 22b which extend over both the p-type transistor region and also the n-type transistor region; electrode 22a separates diffused regions 26a, 28a from diffused regions 26b, 28b, respectively, and electrode 22b separates diffused regions 26b, 28b from diffused regions 26c, 28c, respectively. According to this embodiment, therefore, p-channel and n-channel gates are connected together in each cell 20, with each cell 20 including two such gates. Electrodes 22a, 22b each have three flags or pads for connection, one at each end overlying field oxide 24, and one overlying field oxide 24 disposed between p-type diffused regions 26a, 26b, 26c and respective n-type diffused regions 28a, 28b, 28c. Diffused lines 23 are located at each end of cells 20, with n-type diffused line 23n within the n-well containing p-type diffused regions 26 and p-type diffused line 23p within the p-well containing n-type diffused regions 28; each of diffused lines 23 are available for power distribution and other interconnection among multiple cells. Neighboring cells 20 are isolated from one another, in the example of Figure 2, by field oxide 24 disposed therebetween. In this example, p-type diffused region 26c is isolated from p-type diffused region 26a in the adjacent cell 20 by field oxide 24 of width d_{I}; similarly, n-type diffused region 28c is isolated from n-type diffused region 28a in the adjacent cell 20 by field oxide 24 of width d_{I}.

According to this conventional arrangement, power distribution would be carried out in similar fashion as that discussed above relative to Figures 1a through 1d, with parallel conductors carrying the two bias voltages running in alternating perpendicular directions from level to level. Bias of the wells to the power distribution metal lines would be made by way of contacts to the diffused lines 23n, 23p of Figure 2, in similar manner as noted above relative to Figure 1c. As in the case of cell 2, however, due to the resistivity of diffused lines 23n, 23p, power distribution to cells 20 requires the use of metal connections between the metal power distribution lines and the appropriate active locations within cells 20.

It is an object of the present invention to provide additional flexibility in gate array cell utilization and routing by eliminating the use of parallel metal power distribution lines for at least one metal level.

It is a further object of the present invention to provide such flexibility without requiring additional processing steps in a conventional CMOS process.

Other objects and advantages will be apparent to those of ordinary skill in the art having reference to the following specification together with the drawings.

The invention may be implemented into a gate array of cells, where each of the cells includes an active region at its ends. Self-aligned silicidation ("salicide") of the active regions results in relatively low resistance at the end active regions of the cells. According to the present invention, the salicided active regions at the end of the cells is used for first level power distribution, to which contact is made by stacked metal-2 to metal-1 to salicide contacts. Power distribution is thus moved from the first metal level, greatly increasing signal line routing flexibility and thus cell utilization.

Figures 1a through 1d, and Figure 2, are plan views of conventional basic gate array cells.

Figure 3 is a plan view of a gate array circuit illustrating the layout of its active regions.

Figure 4 is a plan view of a gate array cell according to the preferred embodiment of the invention.

Figure 5 is a cross-sectional diagram illustrating salicidation of the active regions according to the preferred embodiment of the invention.

Figure 6a is a plan view of metal interconnection for purposes of power distribution in the gate array of Figure 3 according to the preferred embodiment of the invention.

Figure 6b is a cross-sectional view of a contact location in the arrangement of Figure 6a.

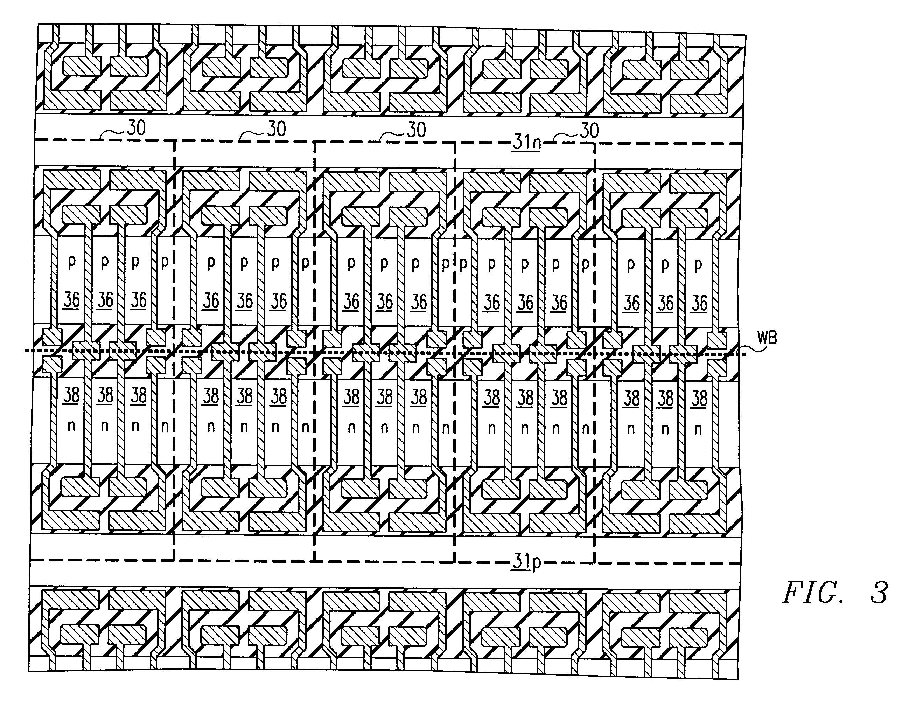

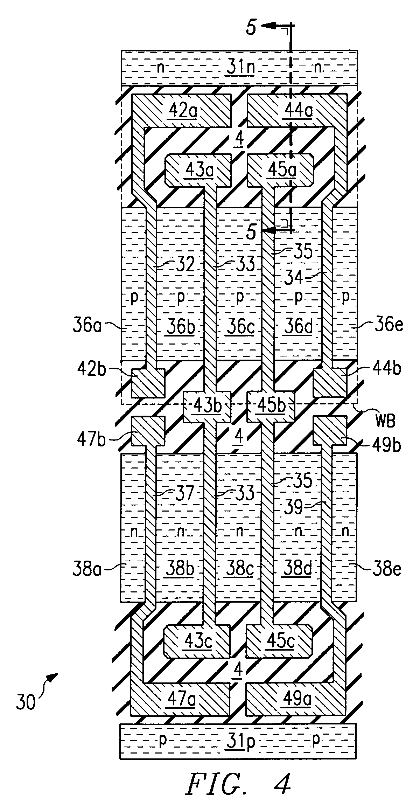

Referring to Figures 3 and 4, a cell arrangement according to the preferred embodiment of the invention will now be described in detail. Figure 3 illustrates the position of cells 30 at the surface of an integrated circuit, with the details of cells 30 not shown in Figure 3 for clarity (such details to be described hereinbelow). As illustrated in Figure 3, each of cells 30 include a portion into which p-channel MOS transistors may be formed (illustrated in Figure 3 by p-type source/drain regions 36) and a portion into which n-channel MOS transistors may be formed (illustrated in Figure 3 by n-type source/drain regions 38). Accordingly, p-type source/drain regions 36 are formed within an n-type region of the substrate, such as an n-well, and the n-type source/drain regions 38 are formed within a p-type region of the substrate, such as a p-well. Well boundary WB, underlying field oxide 4, is illustrated in Figure 3 for reference.

Each of cells 30 also include active region 31n, 31p, separated from the transistor respectively by field oxide 4. Active region 31n is an n-type diffused region within the n-well or n-type portion of the substrate into which the p-type source/drain regions 36 are formed; similarly, active region 31p is a p-type diffused region within the p-well or p-type portion of the substrate into which the n-type source/drain regions 38 are formed. Accordingly, n-type active region 31n makes connection to an n-type region underlying the p-type source/drain regions 36 of cell 30, and p-type active region 30p makes connection to a p-type region underlying n-type source/drain regions 38 of cell 30. Active regions 31n, 31p are shared with adjacent cells 30 above and below (in the view of Figure 3) cell 30.

As will be described in further detail hereinbelow, each of active regions 31n, 31p are clad with a refractory metal silicide, preferably formed in a self-aligned manner. Such silicide-cladding is commonly referred to in the art as "salicide", or self-aligned silicide. Examples of conventional salicide material include platinum silicide, tungsten silicide, and titanium silicide. The preferred method for forming salicide is by the direct reaction of a refractory metal overlying the structure with the underlying silicon; silicide is formed at those locations at which the metal is in contact with silicon, and the metal remains unreacted at those locations where it is not in contact with silicon. Upon removal of the unreacted metal, self-aligned silicide (salicide) remains.

According to the present invention, silicide-clad active regions 31n, 31p are used as power distribution conductors in the gate array including cells 30.

Referring now to Figure 4, gate array cell 30 according to the preferred embodiment of the invention will now be described in detail. As in the case of the conventional basic gate array cells 2, 20 described hereinabove, a gate array integrated circuit utilizing cell 30 according to the preferred embodiment of the invention will have many cells 30, for example two thousand to one hundred thousand cells 30, arranged in a regular pattern over its surface.

Cell 30 as shown in Figure 4 is illustrated at a point in time in its manufacture prior to the formation of metallization and interconnection layers thereover, but where the transistor elements are defined. Cell 30 is of the CMOS type, and as such includes the capability of forming both p-channel and n-channel MOS transistors within its boundaries. Accordingly, cell 30 includes polysilicon electrodes 32, 33, 34, 35 crossing over an active area between field oxide structures 4. According to this example, where a single-well process is used, the active region containing p-type diffused regions 36 is at the surface of an n-type well, having boundary WB as shown in Figure 4.

P-type diffused regions 36a through 36e are preferably formed in conventional self-aligned manner relative to electrodes 32, 33, 34, 35. Furthermore, for purposes of this description, the term "diffused region" is intended to refer to a doped semiconductor region or active region, which may be formed by way of conventional diffusion, ion implantation, or other conventional techniques for doping semiconductor material.

In cell 30, p-type diffused regions 36a, 36b are separated by a channel region underlying electrode 32, p-type diffused regions 36b, 36c are separated by a channel region underlying electrode 33, p-type diffused regions 36c, 36d are separated by a channel region underlying electrode 35, and p-type diffused regions 36d, 36e are separated by a channel region underlying electrode 34. As such, each of electrodes 32, 33, 34, 35 are available to serve as a gate electrode for a p-channel transistor.

Similarly, n-channel transistors are also defined in cell 30 by electrodes 33, 35, 37, 39 overlying an active region between field oxide structures 4; in this example, where a single well process is used, the active region in which n-channel transistors are formed is a p-type surface of the underlying substrate. Of course, other conventional CMOS well designs may also be used, such as a twin-well process or a process in which the p-channel transistors are formed in the substrate and where the n-channel transistors are formed in a p-type well. N-type diffused regions 38a through 38e are preferably formed in conventional self-aligned manner relative to electrodes 33, 35, 37, 39. N-type diffused regions 38a, 38b are separated by a channel region underlying electrode 37, n-type diffused regions 38b, 38c are separated by a channel region underlying electrode 33, n-type diffused regions 38c, 38d are separated by a channel region underlying electrode 35, and n-type diffused regions 38d, 38e are separated by a channel region underlying electrode 39. As such, each of electrodes 33, 35, 37, 39 are available to serve as a gate electrode for a n-channel transistor.

As a result of the configuration of cell 30 according to the preferred embodiment of the invention, four p-channel transistors and four n-channel transistors are available for use in a digital circuit realization. As evident from the foregoing description, each of inner electrodes 33, 35 serve as potential gate electrodes for both a p-channel and an n-channel transistor simultaneously, as each of inner electrodes 33, 35 extends over field oxide structure between p-type diffused regions 36 and n-type diffused regions 38. Electrode 33 has enlarged portions, or flags 43a and 43c overlying field oxide 4 at its two ends, and flag 43b overlying field oxide 4 at its center, to which connection may be made by overlying metallization; electrode 35 is similarly constructed, with flags 45a, 45c at its two ends overlying field oxide 4, and with flag 45b at its center also overlying field oxide 4. As such, cell 30 includes two CMOS transistor pairs with common gates.

In cell 30, however, outer electrodes 32, 34 for the p-channel transistors are not connected, at the polysilicon level, to outer electrodes 37, 39 for the n-channel transistors. Each outer electrode 32, 34 for the p-channel transistors has a pair of flags 42a/42b, 44a/44b, respectively, overlying field oxide 4 on either side of the p-channel active regions, to facilitate connection thereto; similarly, n-channel transistor outer electrodes 37, 39 each have a pair of flags 47a/47b, 49a/49b overlying field oxide 4 on either side of the n-channel active regions. Outer electrode flags 42a, 44a, 47a, 49a are each disposed further from their respective active regions than are flags 43a, 45a, 43c, 45c, so that separate connection thereto may readily be made.

According to the preferred embodiment of the invention, diffused active regions 31n, 31p are disposed outside of field oxide 4, with n-type diffused line 31n near p-type diffused regions 36 and with p-type diffused line 31p near n-type diffused regions 38. As described hereinabove, the next adjacent cell to cell 30 in the vertical direction preferably has its orientation of n-channel to p-channel transistors reversed, so that adjacent cells 30 in the vertical direction can share diffused active regions 31p, 31n.

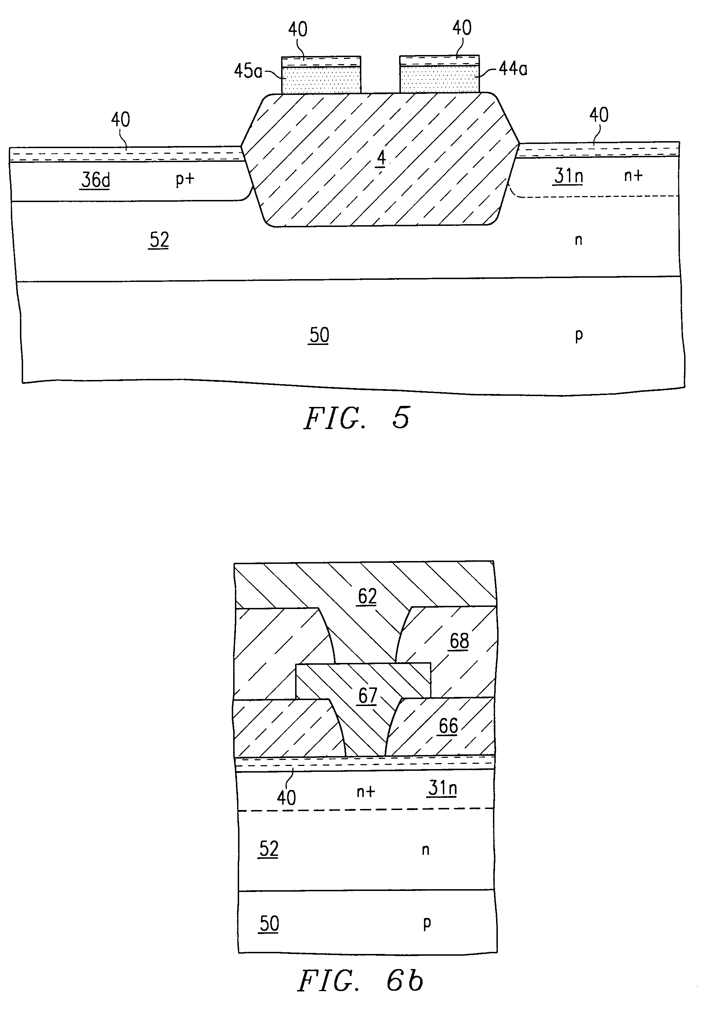

According to the preferred embodiment of the invention, the surface of diffused active regions 31n, 31p is clad with a refractory metal silicide, as is well known in the art for reduction of series resistance of diffused regions. Referring now to Figure 5, a cross-sectional view of a portion of cell 30 will now be illustrated.

As shown in Figure 5, cell 30 is formed at the surface of p-type silicon substrate 50; p-type region 50 may alternatively be formed in an epitaxial layer over a substrate, in a siliconon-insulator layer, or other conventional semiconducting surface of a body. N-type well 52 is formed at the surface of substrate 50, into which p-channel transistors are formed, as discussed above, by the formation of gate electrodes 32, 33, 34, 35 and p-type source/drain regions 36. As shown in Figure 5, p-type source/drain region 36d is formed into well 52, at a location defined by field oxide 4.

On the opposing side of field oxide 4 from source/drain region 36d is n-type active region 31n. As described above, n-type active region 31n is formed as a more heavily-doped diffusion into n-well 52, and as such is available to provide electrical bias to well 52. Polysilicon electrode portions 45a, 44a are in place over field oxide, as shown in Figures 4 and 5.

According to this preferred embodiment of the invention, n-type active region 31n has its surface clad with metal silicide 40, as shown in Figure 5, preferably formed by conventional direct reaction of metal with silicon as noted hereinabove. If formed according to a conventional salicidation process, silicide 40 will be formed at the surface of any exposed silicon element, and will be formed after the polysilicon gate electrode layer is patterned in place; this ensures that silicide 40 does not short circuit the source and drain regions of MOS transistors in cell 30. Accordingly, not only is n-type region 31n silicide clad as shown in Figure 5, but polysilicon electrode portions 45a, 44a, and source/drain region 36d (as well as the other silicon regions in cell 30 of Figure 4) will also be clad with silicide 40.

According to conventional salicide processes, the series resistance of active regions 31n, 31p (as well as of the other silicide-clad regions in cell 30) will be on the order of three to ten ohms/square. This relatively low resistance enables the use of active regions 31n, 31p for power distribution among cells 30 in a gate array circuit. The advantages of salicide power distribution will be discussed in further detail hereinbelow.

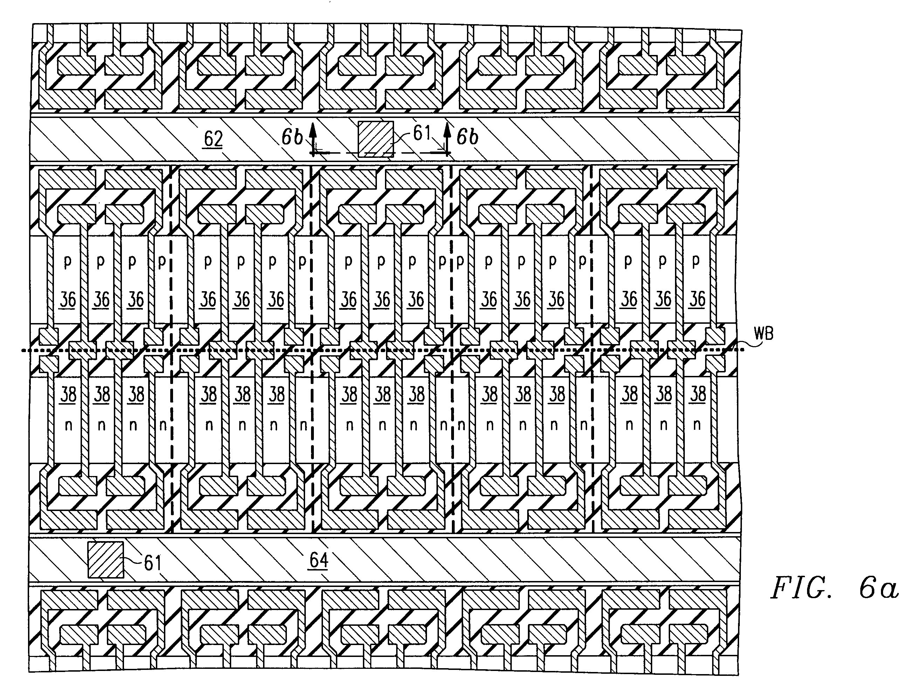

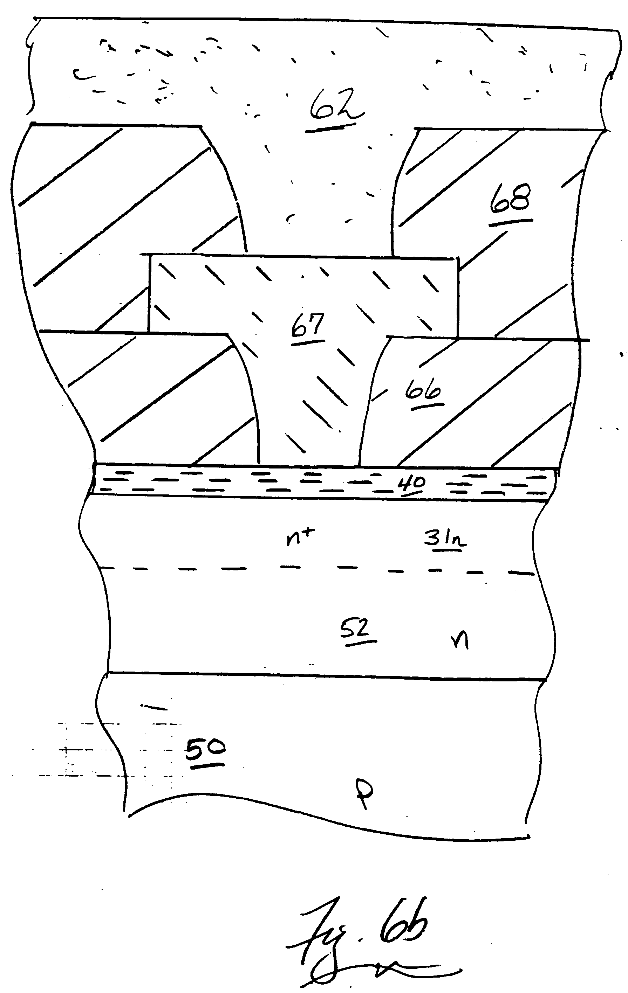

Referring now to Figures 6a and 6b, the overlying metallization for providing power supply voltages V_{dd} and Vₛₛ to an array containing cells 30 will now be described. As shown in Figure 6a, according to this embodiment of the invention, second level metal electrodes 62, 64 are disposed to overlie diffused regions 31n, 31p, respectively (see Figure 3). Second level metal electrodes 62, 64 are connected to diffused regions 31n, 31p at contact locations 63 (as shown in Figure 6a). In this embodiment of the invention, second level metal electrode 62 is biased to V_{dd} and second level metal electrode 64 is biased to ground. Diffused regions 31n, 31p, to which second level metal electrodes 62, 64 are connected, respectively, thus contact the underlying wells to the appropriate bias.

Referring now to Figure 6b, contact location 63 for second level metal electrode 62 according to this embodiment of the invention is illustrated in detail. At location 63, first metal element 67 makes contact to silicide 40 at the surface of diffused region 31n. First metal element 67 overlies interlevel dielectric 66 and makes contact to silicide film 40 at diffused region 31n through a conventional contact opening through interlevel dielectric 66. Second interlevel dielectric 68 overlies first level metal element 67 and interlevel dielectric 66, and has an opening through which second level metal electrode 62 makes contact to first metal level element 67.

It is contemplated that one of ordinary skill in the art will be capable of placing contact locations 63 at the frequency necessary to limit any resistive voltage drop in the power distribution scheme according to the present invention, considering the series resistance value of silicide-clad diffused regions 31n, 31p. It is preferred that the maximum voltage drop along diffused regions 31n, 31p be limited to on the order of 100 mV.

According to this embodiment of the invention, therefore, the only first level metal required for power distribution for cells 30 are elements 67 at contact locations 63. No first level metal lines running the length of the array of cells 30 are thus necessary for power distribution to cells 30. As a result, the flexibility of routing signal lines in first level metal is greatly improved, as there are no limitations created by power distribution lines in any direction. If any of the transistors in a cell 30 require bias to V_{dd} or Vₛₛ, the connection to the appropriate diffused region 31n, 31p may thus be quite short, requiring only a short first level metal strap and appropriate contacts.

Of course, the use of silicide-clad diffused regions for power distribution according to the present invention is also compatible with other metallization systems. For example, a third metal level may cross over second level metal electrodes 62 in a direction perpendicular thereto, to provide additional power distribution bussing. In any case, power distribution using silicide-clad diffused regions according to the present invention reduces the number of metal levels necessary for power distribution, and provides additional flexibility for the routing of signal metal lines.

It is contemplated that the use of silicide-clad surface active regions for power distribution will be beneficial in gate arrays of a wide range of cell layouts, including conventional cells such as cells 2, 20 described hereinabove. However, the particular layout of cell 30 is particularly advantageous in the use of silicide-clad active regions 31n, 31p as power distribution lines, as will now be described. As is evident from Figure 4, transistors of relatively small channel width are implemented in cell 30, in combination with cutoff isolation provided by the outer ones of electrodes 32, 34, 37, 39. Accordingly, since the transistors are relatively small, the source/drain current required by cells 30 is reduced from that required for wider transistors such as those in cell 2 described hereinabove. In addition, the smaller transistors present less capacitive load to prior stages in a circuit implementation than those of conventional cells. Accordingly, to the extent that silicide-clad active regions 31n, 31p are more resistive than conventional metal lines used in power distribution, the use of cell 30 greatly reduces any deleterious effect. Furthermore, it has been observed that the use of silicide-clad active regions 31n, 31p according to the present invention results in reduced noise in the array, as a result of the slight increase in series resistance of the power distribution lines and also the additional capacitance provided by the well junctions into which the active regions are formed.

While the invention has been described herein relative to its preferred embodiments, it is of course contemplated that modifications of, and alternatives to, these embodiments, such modifications and alternatives obtaining the advantages and benefits of this invention, will be apparent to those of ordinary skill in the art having reference to this specification and its drawings. It is contemplated that such modifications and alternatives are within the scope of this invention as subsequently claimed herein.

## Claims

1. An integrated circuit formed at a surface of a silicon body, comprising:
a plurality of cells arranged in an array, each of said cells including a transistor region of a first conductivity type formed at said surface and an interconnection region of a second conductivity type formed at said surface, wherein said interconnection region is separated at said surface from said transistor region by a dielectric structure, and wherein said interconnection region has a silicide film at its surface; and
a metal electrode in contact with the silicide film at the surface of said interconnection, for communicating a power supply voltage.

2. The circuit of claim 1, wherein said transistor region also has a silicide film at its surface.

3. The circuit of claim 1, wherein the interconnection region of adjacent ones of said plurality of cells are in contact with one another.

4. The circuit of claim 1, further comprising:
an intermediate metal element connecting said metal electrode to the silicide film of said interconnection region.

5. An integrated circuit, comprising a plurality of repetitively placed cells arranged in an array at a surface of a silicon body, each of said cells comprising:
a first active region at which p-channel MOS transistors may be formed, said first active region including a p-type source/drain region at the surface of n-type silicon;
a second active region at which n-channel MOS transistors may be formed, said second active region including an n-type source/drain region at the surface of p-type silicon, said second active region separated from said first active region by an oxide structure;
an n-type diffused region at said surface near said first active region and in contact with the n-type silicon of said first active region, said n-type diffused region comprising a silicide film at said surface and connected to a first power supply voltage; and
a p-type diffused region at said surface near said second active region and in contact with the p-type silicon of said second active region, said p-type diffused region comprising a silicide film at said surface and connected to a second power supply voltage.

6. The circuit of claim 5, wherein said first and second active regions each also comprise a silicide film at its surface.

7. The circuit of claim 5, wherein the n-type diffused region of adjacent ones of said plurality of cells are in contact with one another.

8. The circuit of claim 7, wherein the p-type diffused region of adjacent ones of said plurality of cells are in contact with one another.

9. The circuit of claim 7, wherein the p-type diffused region of adjacent ones of said plurality of cells are in contact with one another.

10. The circuit of claim 7, further comprising:
a first metal electrode in contact with the silicide film of said n-type diffused region, and connected to a first power supply voltage; and
a second metal electrode in contact with the silicide film of said p-type diffused region, and connected to a second power supply voltage.

11. The circuit of claim 10, further comprising:
a first intermediate metal element connecting said first metal electrode to the silicide film of said n-type diffused region; and
a second intermediate metal element connecting said first metal electrode to the silicide film of said n-type diffused region.
